(19) Europäisches Patentamt / European Patent Office / Office européen des brevets

(11) **EP 4 120 360 A1**

(12) **EUROPEAN PATENT APPLICATION**

(43) Date of publication:
**18.01.2023 Bulletin 2023/03**

(21) Application number: **21186089.5**

(22) Date of filing: **16.07.2021**

(51) International Patent Classification (IPC):
***H01L 29/423*** (2006.01)        ***H01L 29/739*** (2006.01)
***H01L 29/78*** (2006.01)

(52) Cooperative Patent Classification (CPC):
**H01L 29/7813; H01L 29/42368; H01L 29/66734;**
**H01L 29/7395; H01L 29/7397; H01L 29/7802;**
H01L 29/0878

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **Hitachi Energy Switzerland AG**
**5400 Baden (CH)**

(72) Inventors:
• **GUPTA, Gaurav**
**5600 Aargau (CH)**
• **DE-MICHIELIS, Luca**
**5000 Aarau (CH)**
• **VITALE, Wolfgang Amadeus**
**5000 Aarau (CH)**

(74) Representative: **Epping - Hermann - Fischer**
**Patentanwaltsgesellschaft mbH**
**Schloßschmidstraße 5**
**80639 München (DE)**

(54) **POWER SEMICONDUCTOR DEVICE**

(57)      In an embodiment, the power semiconductor device (1) comprises:
- a semiconductor body (2) having a source region (21) of a first conductivity type and a well region (22) of a second conductivity type different from the first conductivity type, and the well region (22) comprises a channel region (220) directly at the source region (21),
- a gate electrode (31) arranged at the semiconductor body (2) and assigned to the channel region (220), and
- a gate insulator (4) directly between the semiconductor body (2) and the gate electrode (31),
wherein the gate insulator (4) has a non-uniform thickness Tox along the channel region (220) so that, along the channel region (220), the gate insulator (4) is thickest in a first part (44) remote from the source region (21).

FIG 2

FIG 3

EP 4 120 360 A1

**Description**

A power semiconductor device is provided.

Document US 6 503 786 B2 refers to a power MOS device with an asymmetrical channel structure for enhanced linear operation capability.

Document WO 2017/112276 A1 discloses a non-uniform gate oxide thickness for DRAM devices.

Document US 2007/0063269 A1 describes a trench IGBT with an increased short circuit capability.

Embodiments of the disclosure relate to a power semiconductor device that shows improved electrical behavior.

This object is achieved, inter alia, by a power semiconductor device as defined in claim 1. Exemplary further developments constitute the subject-matter of the dependent claims.

In at least one embodiment, the power semiconductor device comprises:

- a semiconductor body having a source region of a first conductivity type and a well region of a second conductivity type different from the first conductivity type, and the well region comprises a channel region starting directly at the source region,
- a gate electrode arranged at the semiconductor body and assigned to the channel region, and
- a gate insulator directly between the semiconductor body and the gate electrode,

wherein the gate insulator has a non-uniform thickness Tox along the channel region so that, along the channel region, the gate insulator is thickest in a first part remote from the source region.

The gate electrode is insulated from the semiconductor body by the gate insulator.

According to at least one embodiment, the at least one gate electrode is partially or completely arranged in at least one trench formed in the semiconductor body. The at least one trench and, thus, the assigned gate electrode may extend through the well region into the drift region, for example, in a direction away from a top side of the semiconductor body. Consequently, the at least one gate insulator is located partially or completely in the assigned trench, too. Hence, the power semiconductor device could be a trench-based device.

Otherwise, the at least one gate electrode and the at least one gate insulator are applied on the top side of the semiconductor body. Thus, the top side may be a planar face.

For example, the at least one source region is in direct contact with the assigned gate insulator and/or is directly at the assigned channel region. The first conductivity type is, for example, n-conductive and, thus, the at least one source region is n-doped.

According to at least one embodiment, the at least one channel region is also of the second conductivity type different from the first conductivity type. The second conductivity type is, for example, p-conductive and, thus, the at least one channel region is p-doped. It is possible that a maximum doping concentration of the at least one channel region is less than a maximum doping concentration of the at least one source region.

According to at least one embodiment, the semiconductor body further comprises a drift region which may be of the first conductivity type, too. For example, the drift region is in direct contact with the gate insulator and/or is directly at the channel region. Along a direction away from the top side of the semiconductor body, the drift region may be located between the channel region and a drain region or a collector region of the semiconductor body. For example, the optional trench may terminate in the drift region.

As an option, the semiconductor body can comprise an enhancement layer. For example, the enhancement layer is located directly between the well region and the drift region and may have a higher maximum doping concentration than the drift region. The enhancement layer can also be of the first conductivity type.

According to at least one embodiment, the well region extends from the top side of the semiconductor body to the drift region. The channel region is part of the well region and may have the same doping concentration. During operation, the electrons flow in the channel region from the source region to the drift region along the gate insulator. The channel region has a thickness in a direction perpendicular to an interface between the gate insulator and the well region, for example, in a nanometer range, exemplarily 1 nm to 50 nm.

According to at least one embodiment, the power semiconductor device is a metal-insulator-semiconductor field-effect transistor, MISFET, a metal-oxide-semiconductor field-effect transistor, MOSFET, an insulated-gate bipolar transistor, IGBT, or a reverse-conducting insulated-gate bipolar transistor, RC-IGBT.

For example, the semiconductor body is of Silicon, Si for short. However, the semiconductor body can alternatively be of a wide-bandgap semiconductor material like SiC, $Ga_2O_3$ or GaN.

The gate insulator is made of any electrically insulating material, which may be an oxide. For example, the gate insulator is of at least one of the following materials: $SiO_2$, $Si_3N_4$, $Al_2O_3$, $Y_2O_3$, $ZrO_2$, $HfO_2$, $La_2O_3$, $Ta_2O_5$, $TiO_2$. Hence, the gate insulator may also be referred to as gate oxide.

According to at least one embodiment, the power semiconductor device is a power device. For example, the power semiconductor device is configured for a maximum voltage of at least 0.2 kV or of at least 0.6 kV or of at least 1.2 kV.

The power semiconductor device is, for example, for a power module in a vehicle to convert direct current from a battery or a fuel cell to alternating current for an electric motor, for example, in hybrid vehicles or plug-in electric vehicles. Moreover, the power semiconductor device can be a fuse, for example, in a vehicle like a car.

For simplification, in the following only one channel region and assigned components are mentioned. If there is a plurality of channel regions and assigned components, the features described below may apply to only one, to a plurality or to all of the channel regions and assigned components.

According to at least one embodiment, the thickness of the gate insulator along the channel region increases monotonically or strictly monotonically towards the drift region. Monotonically means that the thickness is constant or increases, and strictly monotonically means that the thickness always increases towards the drift region.

According to at least one embodiment, along the channel region, the gate insulator has a first part. The first part may be remote from the source region and consequently may be next to the drift region. For example, the first part is a thickest part of the gate insulator seen along the channel region.

According to at least one embodiment, a length of the first part is at least 5% or is at least 10% or is at least 15% of an overall length of the channel region along the gate insulator. Alternatively or additionally, said length is at most 40% or at most 30% or at most 25% of said overall length.

According to at least one embodiment, the gate insulator has a second part which is located next to the source region, seen along the channel region. The gate insulator, along the channel region, may consist of the second part and of the first part.

According to at least one embodiment, the gate insulator has a constant thickness along the channel region in the second part. That is, the only intentional thickness variation of the gate insulator may be in the first part or at a boundary between the first part and the second part.

According to at least one embodiment, the thickness of the gate insulator along the channel region varies by at least 10% or by at least 20% or by at least 30% of a maximum thickness of the gate insulator. For example, the remainder of the gate insulator has a thickness of at most 70% or of at most 80% or of at most 90% of a thickness of the first part.

According to at least one embodiment, the thickness of the gate insulator along the channel region changes in a stepped manner so that there is one or a plurality of steps in the thickness of the gate insulator along the channel region. Otherwise, the thickness of the gate insulator may change in a continuous, step-less manner.

According to at least one embodiment, the gate insulator is of multi-layer fashion so that the gate insulator comprises at least two sub-layers. Otherwise, the gate insulator is of single-layer fashion and comprises only one layer. If there is a plurality of sub-layers, the sub-layers can be made of different materials and/or can have different dielectric constants. The sub-layers may follow directly on top of each other. It is possible that the sub-layers have different sizes so that the sub-layers can be arranged non-congruently. It is also possible that the sub-layers have different thicknesses, alternatively, the sub-layers are all of the same thickness.

According to at least one embodiment, the channel region has a non-uniform channel doping profile along the gate insulator. For example, a doping concentration $N_A$ in the channel region is largest in the first part and consequently may be smallest in the second part.

According to at least one embodiment, the gate electrode has a non-uniform gate electrode work function profile along the channel region, such that a threshold voltage of the gate electrode is highest in the first part. Hence, a work function $\Phi_m$ of the gate electrode in the first part remote from the source region is largest for n-channel devices and smallest for p-channel devices.

According to at least one embodiment, the gate insulator has a non-uniform gate dielectric constant profile along the channel region, such that a relative dielectric constant of the gate insulator is lowest in the first part of the channel region remote from the source region.

According to at least one embodiment, there is the non-uniform thickness profile as well as the non-uniform channel doping profile and/or the non-uniform gate electrode work function profile and/or the non-uniform gate dielectric constant profile. That is, the non-uniform gate insulator thickness profile can be combined with the non-uniform channel doping profile, the non-uniform gate electrode work function profile or the non-uniform gate dielectric constant profile, or with two of the non-uniform channel doping profile, the non-uniform gate electrode work function profile and the non-uniform gate dielectric constant profile, or with all three other non-uniform profiles.

According to at least one embodiment, the power semiconductor device is configured so that both a saturation current and a short-circuit current are decreased, for example, while a collector-emitter saturation voltage $V_{ce-sat}$, and consequently on-state losses, may remain unaffected. This may be true because of the non-uniform thickness profile of the gate insulator where the thickness is increased in the first part while it is decreased in the remaining part of the gate insulator along the channel region, as compared to an analogously set-up reference semiconductor device having a constant thickness of a gate insulator along a channel region.

A power semiconductor device is explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:

Figure 1         is a schematic sectional view of a ref-

**EP 4 120 360 A1**

erence semiconductor device,

Figure 2     is a schematic sectional view of an exemplary embodiment of a power semiconductor device described herein,

Figure 3     is a top view of the power semiconductor device of Figure 2,

Figures 4 to 7     are schematic representations of electric data of power semiconductor devices described herein and of a reference semiconductor device,

Figure 8     is a schematic representation of gate insulator thicknesses of power semiconductor devices described herein and of a reference semiconductor device,

Figures 9 to 12     are simulation results of electric data of power semiconductor devices described herein and of a reference semiconductor device, and

Figures 13 to 19     are schematic sectional views of exemplary embodiments of power semiconductor devices described herein.

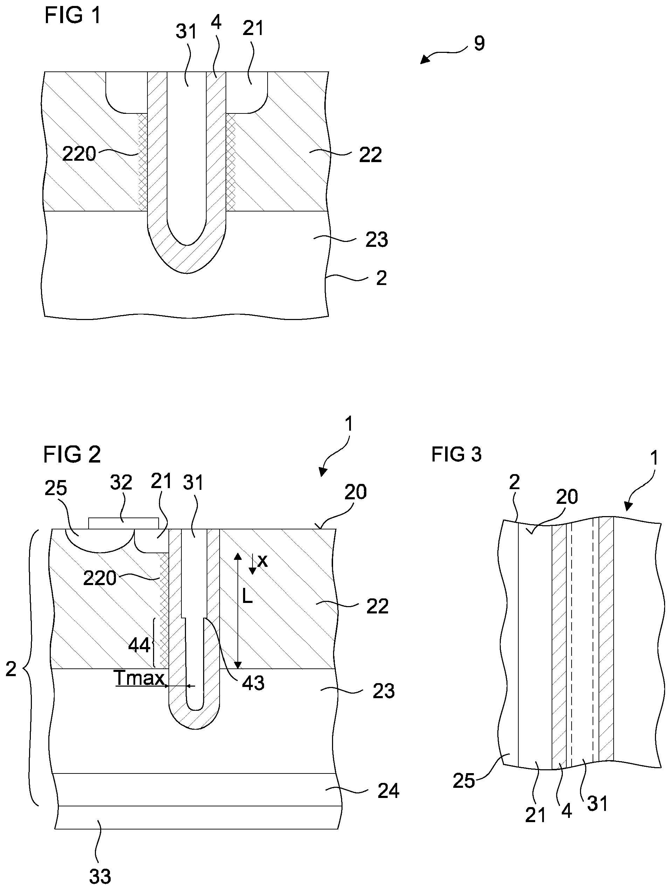

Figure 1 illustrates a reference semiconductor device 9 that corresponds to exemplary embodiments of power semiconductor devices 1 described herein except for a design of a gate insulator 4. Like the power semiconductor devices 1, the reference semiconductor device 9 comprises a semiconductor body 2 which is, for example, of Si.

The semiconductor body 2 comprises a source region 21 and a well region 22 through which a trench passes. In the well region 22, there is a channel region 220. When the reference semiconductor device 9 is in an on-state, then electrons flow from the source region 21 to a drift region 23 through the channel region 220 which is located directly at a gate insulator 4.

The source region 21 is of a first conductivity type, like n-conducting, and the well region, and consequently the channel region 220, is of a second, different conductivity type, like p-conducting. In the trench, there is a gate electrode 31 that is separated from the semiconductor body 2 by means of the electrically insulating gate insulator 4. The trench and, hence, the gate electrode 31 ends in the drift region 23 of the semiconductor body 2. The drift region 23 is of the first conductivity type, too.

In the reference semiconductor device 9, the gate insulator 4 is of constant thickness at least all along the channel region 220. Contrary to that, in the exemplary embodiments of the power semiconductor devices 1, the gate insulator 4 has a non-uniform thickness along the channel region 220. Note that a shape of the channel region 220 is drawn only very schematically.

According to the power semiconductor device 1 of Figures 2 and 3, the gate insulator 4 comprises one step 43 at which the thickness of the gate insulator 4 changes in an abrupt manner. After the step, seen along the channel region 220, the gate insulator 4 comprises a first part 44 in which the gate insulator 4 has its maximum thickness Tmax. Here, the term 'along the channel region 220' means, for example, from the point where the channel region 220 starts at the gate insulator 4 close to the source region 21, and until the drift region 23 begins, that is, means along a direction x from the source region 21 until the drift region 23, for example, directly at the gate insulator 4. Hence, the region of the gate insulator 4 being of interest here and in the following has a length L which corresponds to a distance between the source region 21 and the drift region 23 directly at the gate insulator 4. Hence, the length L may be defined as the length of the second conductivity type layer between the layers of the first conductivity type, for example, the source region 21 and the drift region 23, wherein the drift region 23 may comprise an enhancement layer of higher doping concentration and a layer of lower doping concentration, not illustrated in the Figures.

Both the source region 21 and the well region 22 may be electrically connected by means of at least one source electrode 32 which is located at a top side 20 of the semiconductor body 2.

As on option, to electrically contact the channel region 220, there can be at least one plug 25 at the top side 20 of the semiconductor body 2. The plug 25 may have a different thickness than the well region 22 so that the plug 25 can extend deeper or shallower into the semiconductor body 2 than the well region 22. Further, the thicknesses of the source region 21 and of the plug 25 can be the same or can be different.

Both the source region 21 and the at least one plug 25 may be electrically connected by means of the at least one source electrode 32 which is located at the top side 20. Exemplarily, the plug 25 has a higher maximum doping concentration than the well region 22 or the channel region 220. The depth of the plug may be lower, deeper or the same as of the well region/channel region.

For example, the power semiconductor device 1 is an insulated-gate bipolar transistor, IGBT for short. Hence, at as side of the drift region 23 remote from the well region 22, there is a collector region 26 which is of the second conductivity type, too. Additionally, as a further option there can be a buffer region of the first conductivity type between the drift region 23 and the collector region 26, not shown. A doping concentration of the buffer region can be higher than that of the drift region 23. At the collector region 26, there is a collector electrode 34.

Seen in top view of the top side 20, the trench accommodating the gate electrode 31 may be of extended fashion. The source region 21, the at least one plug 25 as well as the channel region 21 may be arranged symmetrically on both sides of the trench, see Figure 3.

For example, the thickness of the gate insulator along the channel region out of the first part is between 20 nm and 80 nm inclusive or is between 40 nm and 80 nm inclusive. Alternatively or additionally, in the first part said thickness is between 120 nm and 250 nm inclusive or is between 120 nm and 180 nm inclusive.

For example, maximum doping concentrations of the source regions 21, the collector region 26 or instead of a drain region 24 and the at least one plug 25 are at least $1 \times 10^{18}$ cm$^{-3}$ or at least $5 \times 10^{18}$ cm$^{-3}$ or at least $1 \times 10^{19}$ cm$^{-3}$ and/or at most $5 \times 10^{20}$ cm$^{-3}$ or at most $2 \times 10^{20}$ cm$^{-3}$ or at most $1 \times 10^{20}$ cm$^{-3}$. Further, a maximum doping concentration of the well region 22 and, thus, of the channel region 220, may be at least $5 \times 10^{16}$ cm$^{-3}$ or at least $1 \times 10^{17}$ cm$^{-3}$ and/or at most $5 \times 10^{19}$ cm$^{-3}$ or at most $5 \times 10^{18}$ cm$^{-3}$.

Depending on the voltage class of the power semiconductor device 1, a maximum doping concentration of the drift region 23 may be at least $1 \times 10^{11}$ cm$^{-3}$ or at least $1 \times 10^{12}$ cm$^{-3}$ or at least $1 \times 10^{13}$ cm$^{-3}$ and/or at most $1 \times 10^{17}$ cm$^{-3}$ or at most $5 \times 10^{16}$ cm$^{-3}$ or at most $1 \times 10^{16}$ cm$^{-3}$.

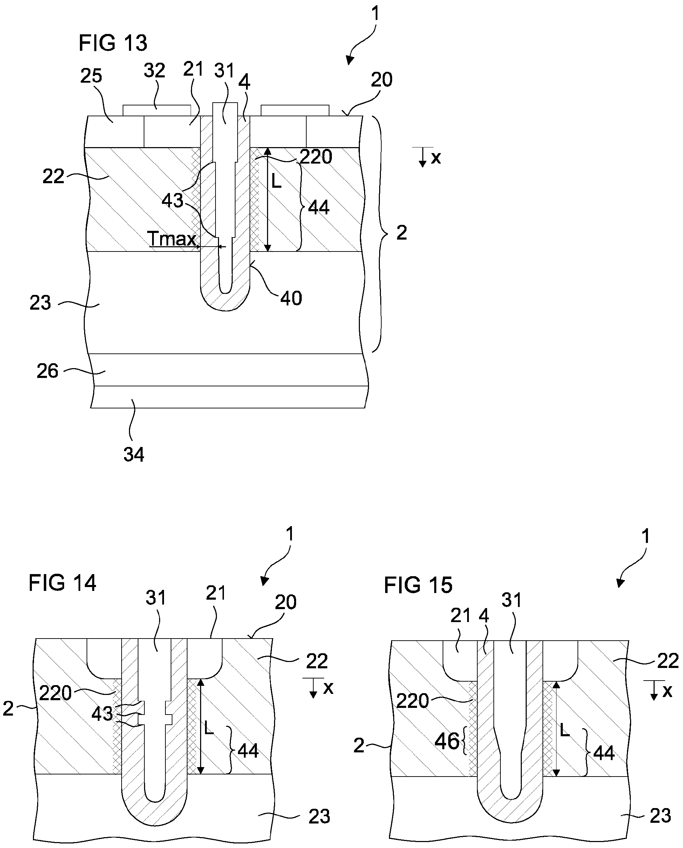

In Figures 2 and 3, the source region 21 and the at least one plug 25 are located along only one side of the gate electrode 31 so that there is a channel region 220 only along one outward side of the gate insulator 4. However, the source region 21 as well as the at least one plug 25 can also be located along two sides of the gate electrode 31, compare, for example, Figure 13, or all around the gate electrode 31, when seen in top view.

Otherwise, the same as to Figure 1 may also apply to Figures 2 and 3.

The concept of the gate insulator 4 having the non-uniform thickness is explained in the following.

For a power semiconductor device 1, exemplarily for low frequency applications, it may be desirable to have on-state losses as low as possible in order to minimize the total electrical losses. Further, from a device reliability point of view, it may be advantageous to have a low short circuit current. Thus, a power semiconductor device 1 with minimized on-state losses and improved short circuit capability may be desired.

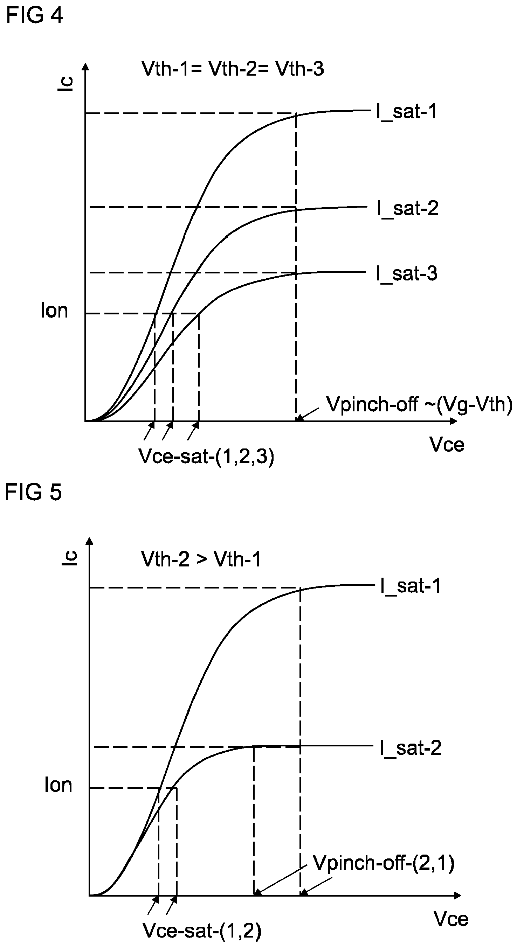

However, some means to lower an on-state voltage drop Vce-sat, for example, by reducing the channel length L or increasing a channel width W, often result in an undesired higher saturation current I$_{sat}$, as illustrated schematically using output characteristics I$_c$ vs. V$_{ce}$, see Figure 4. The higher I$_{sat}$ is directly related to a higher short circuit current I$_{sc}$, adversely affecting the short circuit capability of the power semiconductor device 1. On the other hand, raising a threshold voltage V$_{th}$ of the power semiconductor device 1 in order to lower I$_{sat}$, for example, by increasing a channel doping concentration, results in higher V$_{ce-sat}$ as illustrated in Figure 5. Thus, Figures 4 and 5 are schematics of typical output characteristics of an IGBT with a uniform threshold profile along the whole channel region, in Figure 4 for a same V$_{th}$ and different channel resistance, and in Figure 5 for different threshold voltages V$_{th}$.

Other techniques to reduce the short-circuit current such as:

  a) increasing the channel length L,
  b) reducing an anode injection efficiency, by reducing an anode implant dose,
  c) reducing the channel width, by decreasing a source coverage along the trench, and
  d) reducing the channel width, by increasing a cell pitch,

also undesirably result in higher on-state losses. Moreover, techniques such as d) can also adversely affect the breakdown capability of the power semiconductor device 1. Reducing gate biasing in order to reduce short-circuit current may also not be desirable as it leads to unstable dynamic behavior and moreover it is mainly defined by the application requirements.

Thus, there is a trade-off between minimizing the on-state losses and decreasing the short circuit current in a conventional MISFET or IGBT device. For an application requiring improved short circuit capability, it is desirable to be able to decrease the short circuit current I$_{sc}$ without affecting V$_{ce-sat}$.

Another possibility to affect the electric behavior at a gate electrode in non-IGBT devices is, for example, using relatively thicker gate-oxides at trench bottom, mainly for prevention against hot carrier injection. However, the extent of thicker oxide may be limited to an n-base region and may not be extended into a p-doped region where it would have affected MOS channel characteristics. Moreover, asymmetry in the channel doping or gate oxide thickness may be introduced with respect to a neighbouring cell and not in the channel region of the same cell. The use of a relatively thicker gate-oxide, with a thickness of, for example, 180 nm to 250 nm, uniformly along trench sidewalls and a trench bottom may also be possible to improve an IGBT short-circuit capability by raising its threshold voltage. However, this approach will suffer from a higher on-state voltage drop. Another method of fabricating a non-uniform gate oxide for DRAM device may use relatively thicker oxide at the top section of the recess sidewall.

With the power semiconductor device 1 described herein, the trade-off between on-state losses and short circuit current is improved by improving the latter without adversely affecting the former. Differently from other approaches, the described design features a non-uniform threshold voltage profile along the channel region 220 next to the gate insulator 4 to lower down the saturation current for a given Vce-sat. The proposed non-uniform V$_{th}$ in the power semiconductor device 1 described herein is achieved by implementing the non-uniform gate insulator thickness along the channel region 220. The described power semiconductor device 1 does not adversely affect the breakdown capability and more so ever the turn-off losses of the power semiconductor device 1. In addition, the described concept is applicable to any MOS device in general such as power-MOSFET or IGBT or reverse conducting IGBT devices and is even compatible with both planar and trench architectures.

With the power semiconductor device 1 described herein, an improved MISFET, MOSFET or IGBT device with an enhanced short circuit capability is introduced without a detrimental effect on the on-state losses. The improved design also relaxes the design constraints of the IGBT, enabling the possibility to independently explore the other methods mentioned above to minimize the on-state losses which are normally limited by the short circuit capability of the respective device.

In the following, some theoretical background to the idea of the semiconductor device 1 described herein is presented.

For a reference long channel MOS device 9, it is known that a channel pinch-off at high $V_{ce}$ is responsible for the current saturation in the output characteristics, which ultimately determines the short circuit current. The channel pinch-off voltage $V_{pinch-off}$ is determined by the threshold voltage $V_{th}$. In particular, the channel starts pinching-off near its drain end, at $x = L$ where L is the channel length, when the applied bias $V_{ce}$ exceeds the pinch-off voltage $V_{pinch-off} \approx (V_g - V_{th})$, where $V_g$ is the applied gate voltage. At such applied $V_{ce}$, the voltage drop perpendicular to the channel is less than $V_{th}$ and therefore the channel cannot sustain any longer near the drain end.

However, for a more detailed understanding of the device, it should be considered that the channel pinch-off, however, is more of a local phenomenon, taking place specifically near the drain end of the channel. Therefore, more correctly, it is the local threshold voltage, $V_{th}(x)$, which determines the pinch-off point and, thus, the saturation current. This implies that it is possible to lower the $V_{pinch-off}$ by locally increasing $V_{th}$ (L) at the channel end, that is, in the first part 44 near the drift region 23. Further, in order to keep the overall channel resistance and thereby $V_{ce-sat}$ unaffected, $V_{th}(x)$ can be decreased in the rest of the channel.

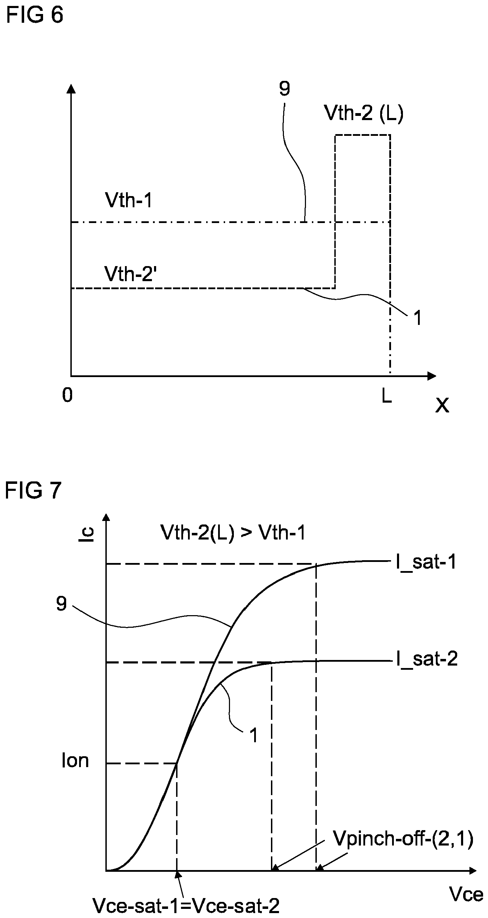

This is illustrated schematically in Figure 6 where the curve referring to the reference semiconductor device 9 comprises a uniform threshold voltage $V_{th-1}$ profile along the whole channel. The curve for the power semiconductor device 1 on the other hand consists of a non-uniform $V_{th}$ profile along the channel, where $V_{th}$ is locally raised near the channel end, that is, in the first part 44, such that $V_{th-2}(L) > V_{th-1}$ in order to lower the pinch-off point, while $V_{th-2}' < V_{th-1}$ in the rest of the channel to keep the overall channel resistance the same. In this way, saturation current and thereby short circuit current can be significantly reduced without affecting the on-state losses as illustrated in the schematic output in Figure 7. Local $V_{th}$ variation thus holds the key for improved short circuit capability of a MISFET or MOSFET or an IGBT device.

$V_{th}$ of the channel is the function of various other MOS cell design parameters as indicated in below equation:

$$V_t = V_{fb} + 2\Phi_B + \frac{\sqrt{qN_a 2\varepsilon_S 2\Phi_B}}{C_{ox}}$$

where $V_t$ is the threshold voltage, $V_{fb}$ is the flatband voltage, $V_{fb} = (\phi_m - \phi_s)$ where $\phi_m$ and $\phi_s$ are the gate metal and the semiconductor work function, respectively. $N_a$ is the channel body doping, $\varepsilon_s$ is the permittivity of the semiconductor, $C_{ox}$ is the gate insulator capacitance, and $\phi_B$ is the semiconductor surface potential and:

$$\Phi_B = kt \ln \frac{N_a}{n_i}$$

where k is the Boltzmann constant, T is the temperature and $n_i$ is the intrinsic carrier concentration of the semiconductor.

Therefore, the required non-uniform $V_{th}$ profile across the channel with relatively higher $V_{th}$ in the first part 44 can be achieved by introducing a non-uniformity in one or in any combination of the following MOS design parameters:

    1. channel doping profile, $N_a$ (x),
    2. gate oxide thickness, Tox (x), as detailed herein,
    3. gate dielectric, $\varepsilon_{ox}$ (y), and/or
    4. gate metal work function, $\phi_m$ (x), since $V_{fb} = (\phi_m - \phi_s)$.

In the following, the focus is on gate insulator thickness variation, but said thickness variation can of course be combined with a varying channel doping profile, a varying gate dielectric and/or a varying gate metal work function.

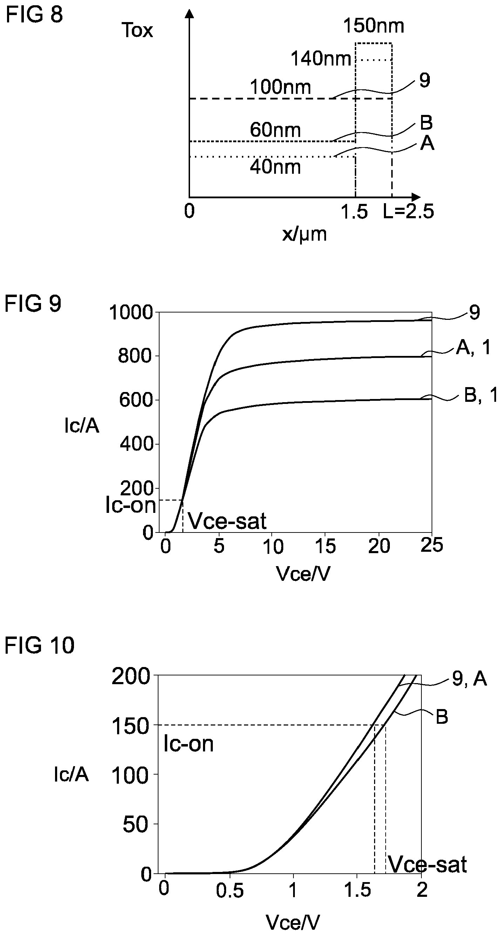

Figures 1 and 2 above show schematic cross-sections of the reference semiconductor device 9 with uniform gate insulator thickness profile and of the power semiconductor device 1 with the non-uniform gate insulator thickness profile as implemented in the simulations presented below. Three different gate-oxide profiles were investigated, see Figure 8. The design referring to the reference semiconductor device 9 has a uniform gate-oxide thickness Tox of 100 nm, which served as a reference. In design A of the power semiconductor device 1, Tox in the first part 44 was raised to 140 nm in order to increase the local $V_{th}$ (L) at that point, while Tox was reduced to 40 nm in the remaining part of the channel region 220 as to maintain the same on-state as that of the reference semiconductor device 9.

While in design B of the power semiconductor device 1, Tox at the first part 44 was further raised to 150 nm to obtain an even higher local $V_{th}$ (L) than that of design A, with a thickness Tox in the remainder of the gate insulator 4 of 60 nm. The effect of these gate-oxide profiles is clearly visible on the simulated output characteristics in Figure 9, where clear reduction in $I_{sat}$ can be observed for designs A and B due to higher local $V_{th}$ (L) which lowers down the pinch-off point without at an expense of $V_{ce-sat}$, which remains practically the same in the reference semiconductor device 9 and in the designs A.

Design B with even greater Tox at the first part 44 shows further improvement in $I_{sat}$, however, with slightly higher $V_{ce-sat}$ which is increased by about 5% as compared to the reference semiconductor device 9, see Figure 10. This is attributed to relatively thicker Tox in the remainder of the gate insulator 4 along the channel region 220.

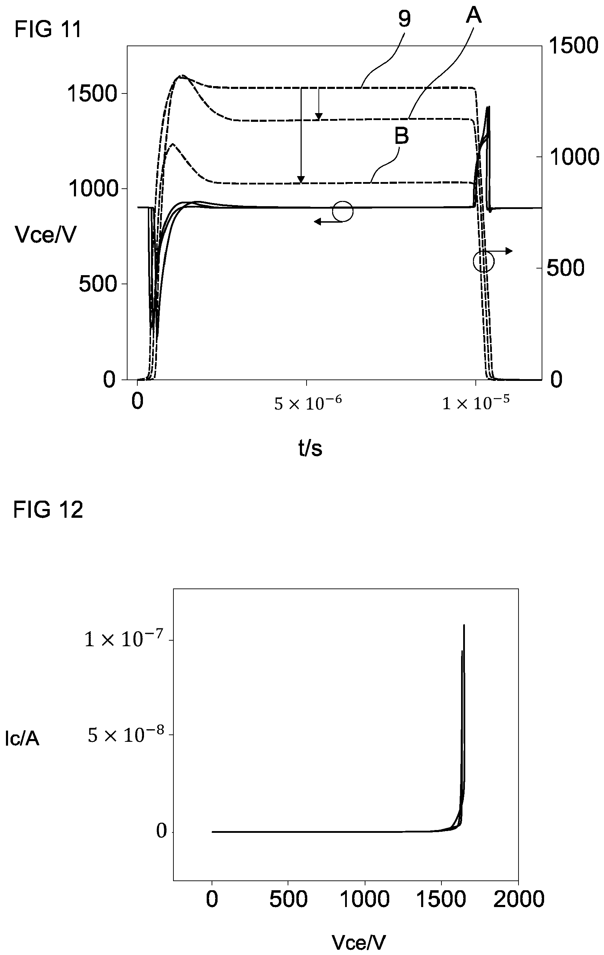

As shown in Figure 11, a clear reduction, for example, of 20% or 40%, in the short circuit current can be observed for designs A and B, compared with the reference semiconductor device 9, as expected.

As shown in Figure 12, the breakdown characteristics of the device remain unaffected with varying gate insulator profiles as expected. Switching losses Eoff remain largely unaffected with Tox profile variation, compare the list below that summarizes the simulation results for designs A and B with different Tox profiles.

Reference semiconductor device 9:

- gate oxide profile: uniform, 100 nm;
- Vce-sat at 150 A: 1.619 V;
- $V_{th}$ at 10 mA: 4.30 V;
- Eoff: 12.69 mJ;
- Isc := 100%.

Design A of the power semiconductor device 1:

- gate oxide profile: non-uniform, 40 nm and 140 nm;
- Vce-sat at 150 A: 1.633 V;
- $V_{th}$ at 10 mA: 5.56 V;
- Eoff: 13.10 mJ;
- Isc := about 90% of Isc of the reference semiconductor device 9.

Design B of the power semiconductor device 1:

- gate oxide profile: non-uniform, 60 nm and 150 nm;
- Vce-sat at 150 A: 1.700 V;
- $V_{th}$ at 10 mA: 5.94 V;
- Eoff: 13.09 mJ;
- Isc := about 70% of Isc of the reference semiconductor device 9.

In these devices 9, A, B, the length L of the channel is in each case 2.5 $\mu$m, and the first part 44 in designs A, B has a length of 1.0 $\mu$m.

In the exemplary embodiment of the power semiconductor device 1 of Figure 13, the thickness of the gate insulator 4 changes in two steps 43. It is possible that the second step is larger than the first step, so that the thickness increase is larger at the step 43 close to the drift region 23, or vice versa. Thus, the thickness Tox of the gate insulator 4 increases monotonically towards the drift region 23.

As it is possible in all other exemplary embodiments of the power semiconductor device 1, an outward side 40 of the gate insulator 4 facing the semiconductor body 2 may be of planar fashion, at least along the channel region 220. Hence, the thickness variation of the gate insulator 4, like the steps 43, may affect an interior side of the gate insulator 4 only, the interior side faces the gate electrode 31.

Moreover, it is illustrated that the power semiconductor device 1 of Figure 13 is not an IGBT, but a MOSFET or MISFET. Consequently, the power semiconductor device 1 comprises a drain region 24 instead of the collector region 26. Hence, at as side of the drift region 23 remote from the well region 22, there is the drain region 24 which is of the first conductivity type, too, but, for example, with a maximum doping concentration higher than in the drift region 23. At the drain region 24, there is a drain electrode 33.

Of course, all the gate insulator designs of the IGBT power semiconductor devices 1 can apply for the MOSFET and MISFET power semiconductor device 1, and vice versa.

Further, all the power semiconductor devices 1 could be configured as a reverse-conducting IGBT. A reverse-conducting IGBT comprises a collector region of the second conductivity type alternating with shorts of the first conductivity type.

Otherwise, the same as to Figures 2 to 12 may also apply to Figure 13, and vice versa.

According to Figure 14, the gate insulator 4 comprises a plurality of the steps 43, and the thickness is not monotonically increasing. Thus, there can be a minor first step to higher thicknesses near the source region 21 and a minor second step back to the original thickness, and there is a major third step to a higher, final thickness next to the drift region 23.

Otherwise, the same as to Figures 2 to 13 may also apply to Figure 14, and vice versa.

In Figure 15, it is illustrated that the thickness changes not in a stepped manner, but continuously at a beginning of the first 44. A transitional region 46, in which the thickness Tox changes, amounts, for example, to at least 2% and/or to at most 15% or to at most 10% or to at most 5% of the length L. Similar to Figures 13 or 14, there may be more than one such transitional region 46.

Otherwise, the same as to Figures 2 to 14 may also apply to Figure 15, and vice versa.

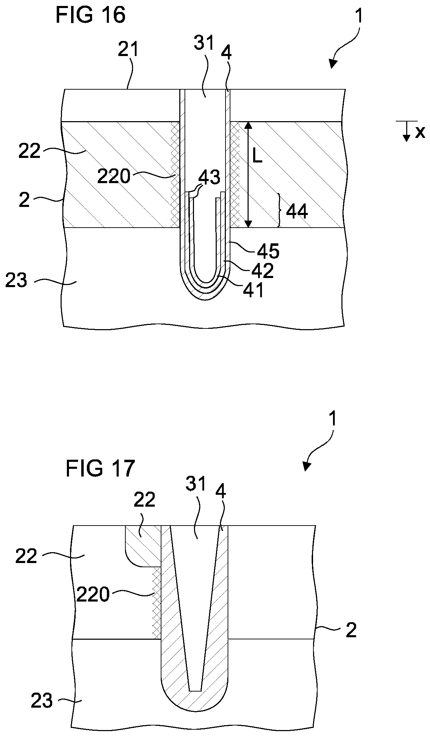

In the previous exemplary embodiments, the gate insulator 4 is of a single continuous layer of the same material and having the varying thickness. Contrary to that, see Figure 16, the gate insulator 4 is of multi-layer fashion. For example, the gate insulator 4 comprises a third sub-layer 45 next to the semiconductor body 2 and extending completely between the latter and the gate electrode 31. Moreover, there is a first sub-layer 41 next to the gate electrode 31 and reaching into the drift region 23, as well as a second sub-layer 42 between the first and third sub-layers 41, 45. The first sub-layer 41 is only partially present through the well region 22 and is not present near the source region 21.

For example, the first sub-layer 41 it the thickest one of the sub-layers, and the second sub-layer 42 or alternatively the third sub-layer 45 is the thinnest sub-layer. Each one of the sub-layers 41, 42, 45 may have a thickness not varying within the respective sub-layer 41, 42, 45, so that the sub-layers 41, 42, 45 may each be of constant thickness. Where the first and second sub-layers 41, 42 end, there are the steps 43. Hence, the sub-layers 41, 42, 45 are not congruent. All the sub-layers 41, 42, 45 can be of the same material or can otherwise be of different materials.

Optionally, a length along which the second sub-layer 42 protrudes from the first sub-layer 41 amounts to at most 50% or to at most 30% of an extent of the first part 44 along the length L.

Otherwise, the same as to Figures 2 to 15 may also apply to Figure 16, and vice versa.

In Figure 17 it is illustrated that a thickness of the gate insulator 4 increases in a strictly monotonically manner, for example, in a linear manner, throughout the well region 22. It is also possible that said thickness increases in a strictly monotonically manner, for example, in a linear manner, along the whole gate insulator 4, that is, also at the source region 21 and/or in the drain region 23.

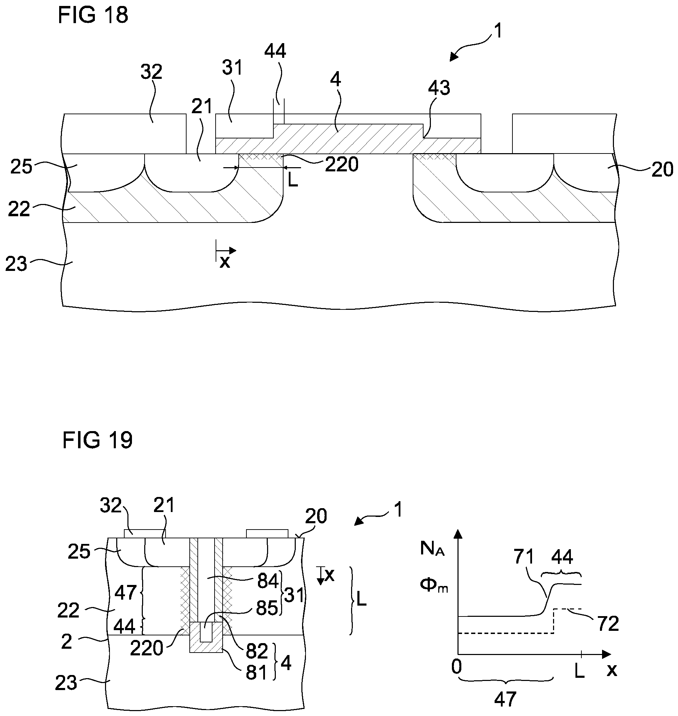

According to Figure 18, the power semiconductor device 1 is of a planar design and not of a trench design like, for example, the power semiconductor device 1 of Figures 2 and 3. Hence, the top side 20 is planar, and the gate insulator 4 and the gate electrode 31 are applied on the top side 20. Consequently, the length L between the source region 21 and the drift region 23 is in parallel with the top side 20, and not like in the other exemplary embodiments perpendicular to the top side 20. The same applies to the direction x along which the thickness Tox varies.

In Figure 18, the channel region 220 protrudes from the source region 21 in a lateral direction, that is, in parallel with the top side 20, and extends below the gate insulator 4. Also the source region 21 may extend below the gate insulator 4, but less far.

All the above-mentioned different designs of the gate insulator 4 can analogously be applied to the planar concept of Figure 18, both in case of a MISFET or MOSFET as well in case of an IGBT. Hence, the same as to Figures 2 to 17 can also apply to Figure 18.

Moreover, in Figure 19 it is illustrated that there is not only the non-uniform gate insulator thickness profile, but also a non-uniform gate dielectric constant profile because of at least two different materials 81, 82, the gate insulator 4 is composed of. That is, the thickness of the gate insulator 4 varies along the channel region 220.

For example, a difference of the relative dielectric constant along the channel region 220 because of the at least two different materials 81, 82 is at least 2.0 or is at least 3.0 or is at least 3.5. Alternatively or additionally, said difference is at most 50 or is at most 25. When comparing the respective relative dielectric constants, text book values for the respective materials at room temperature, that is, 300 K, and at a frequency of a varying electric field of at most 1 kHz may be used. If there is only the non-uniform gate insulator thickness profile and a uniform gate dielectric constant profile, the gate insulator 4 can be of a single material.

Additionally or alternatively to the non-uniform gate dielectric constant profile, there can be a non-uniform gate electrode work function profile 72 of the gate electrode 31. Hence, the gate electrode 31 can include a first gate material 84 next to the source region 21 and a second gate material 85 next to the drain region 23. The gate materials 84, 85 may change where the materials 81, 82 of the gate insulator 4 change. Hence, a work function $\Phi_m$ of the gate electrode 31 in the first part 44 remote from the source region 21 is largest for n-channel devices and smallest for the p-channel devices.

For example, a work function difference of the gate electrode along the channel region 220 is at least 0.7 eV or is at least 1.0 eV or is at least 1.1 eV. This applies, for example, when the gate electrode 31 is based on poly-silicon. If metals like Li, Zn, Hf for a low work function, or metals like Pt, Pd or Au for a high work function are also considered, the work function difference may be at least 1.3 eV or at least 1.4 eV. For example, the work function difference is at most 2.0 eV or at most 1.5 eV.

For example, the second gate material 85 is $p^+$-doped poly-silicon having a work function $\Phi_m$ of about 5.22 eV. For example, the first gate material 84 is $n^+$-doped poly-silicon having a work function $\Phi_m$ of about 4.1 eV. Although based on silicon, these first gate materials 84 and second materials 85 may be referred to as different gate electrode metals.

Accordingly, there is a step in the non-uniform gate electrode work function profile 72 at the interface between the first part 44 and the second part 47, see the insert in Figure 19.

Additionally or alternatively to the non-uniform gate dielectric constant profile and/or the non-uniform gate electrode work function profile 72, there can be a non-uniform channel doping profile 71. That is, a doping concentration $N_A$ in the well region 22 varies along the channel region 220.

For example, a maximum doping concentration present in the non-uniform channel doping profile 71 is at least $5 \times 10^{16}$ cm$^{-3}$ and at most $5 \times 10^{19}$ cm$^{-3}$ and/or a minimum doping concentration present in the non-uniform channel doping profile 71 is at most $2 \times 10^{17}$ cm$^{-3}$

or at most $1 \times 10^{17}$ cm$^{-3}$. The maximum doping concentration may be present in the first part 44, and the minimum doping concentration may be present in the second part 47. Throughout the first part 44 and the second part 47, respectively, the doping concentration $N_A$ may be constant so that the doping concentration $N_A$ varies in a stepped manner, for example. However, a step in the doping concentration $N_A$ does not need to exactly follow a theta function or unit step function, but there can be of sinusoidal shape, see the insert in Figure 19. Said step may be at the location where the materials 81, 82 of the gate insulator 4 change.

Such at least one of the non-uniform gate electrode work function profile 72, the non-uniform gate insulator dielectric constant profile and the non-uniform channel doping profile 71 can be present analogously in all the other exemplary embodiments, too.

Otherwise, the same as to Figures 2 to 18 may also apply to Figure 19, and vice versa.

The components shown in the figures follow, unless indicated otherwise, exemplarily in the specified sequence directly one on top of the other. Components which are not in contact in the figures are exemplarily spaced apart from one another. If lines are drawn parallel to one another, the corresponding surfaces are exemplarily oriented in parallel with one another. Likewise, unless indicated otherwise, the positions of the drawn components relative to one another are correctly reproduced in the figures.

The power semiconductor device described here is not restricted by the description on the basis of the exemplary embodiments. Rather, the power semiconductor device encompasses any new feature and also any combination of features, which includes any combination of features in the patent claims, even if this feature or this combination itself is not explicitly specified in the patent claims or exemplary embodiments.

List of Reference Signs

| | |
|---|---|
| 1 | power semiconductor device |
| 2 | semiconductor body |
| 20 | top side |
| 21 | source region |
| 22 | well region |
| 220 | channel region |
| 23 | drift region |
| 24 | drain region |
| 25 | plug |
| 26 | collector region |
| 31 | gate electrode |
| 32 | source electrode |
| 33 | drain electrode |
| 34 | collector electrode |
| 4 | gate insulator |
| 40 | outward side |

| | |
|---|---|
| 41 | first sub-layer of the gate insulator |
| 42 | second sub-layer of the gate insulator |
| 43 | step |
| 44 | first part |
| 45 | third sub-layer of the gate insulator |
| 46 | transitional region |
| 47 | second part |
| 71 | non-uniform channel doping profile |
| 72 | non-uniform gate electrode work function profile |
| 81 | first material of the gate insulator |
| 82 | second material of the gate insulator |
| 84 | first gate material |
| 85 | second gate material |
| 9 | reference semiconductor device |
| A | first exemplary power semiconductor device |
| B | second exemplary power semiconductor device |
| Isat | saturation current |
| L | length of the channel region along the gate insulator |
| Tmax | maximum thickness of the gate insulator |
| Tox | thickness of the gate insulator along the channel region |
| $V_{th}$ | threshold voltage |
| x | length along the channel region |

**Claims**

1. A power semiconductor device (1) comprising:

   - a semiconductor body (2) having a source region (21) of a first conductivity type and a well region (22) of a second conductivity type different from the first conductivity type, and the well region (22) comprises a channel region (220) directly at the source region (21),
   - a gate electrode (31) arranged at the semiconductor body (2) and assigned to the channel region (220), and
   - a gate insulator (4) directly between the semiconductor body (2) and the gate electrode (31),

   wherein the gate insulator (4) has a non-uniform thickness Tox along the channel region (220) so that, along the channel region (220), the gate insulator (4) is thickest in a first part (44) remote from the source region (21).

2. The power semiconductor device (1) according to the preceding claim,
   wherein the gate electrode (31) is at least partially arranged in a trench formed in the semiconductor body (2) and along the channel region (220).

3. The power semiconductor device (1) according to claim 1, wherein the gate electrode (31) and the gate insulator (4) are arranged on a planar top side (20) of the semiconductor body (2).

4. The power semiconductor device (1) according to any one of the preceding claims, wherein:

   - the source region (21) is in direct contact with the gate insulator (4) and the channel region (220),
   - the semiconductor body (2) further comprises a drift region (23) of the first conductivity type in direct contact with the gate insulator (4) and directly at the well region (22), and
   - the power semiconductor device (1) is a metal-insulator-semiconductor field-effect transistor, MISFET, a metal-oxide-semiconductor field-effect transistor, MOSFET, an insulated-gate bipolar transistor, IGBT, or a reverse-conducting insulated-gate bipolar transistor, RC-IGBT.

5. The power semiconductor device (1) according to the preceding claim, wherein, along the channel region (220), the gate insulator (4) is thickest directly at the drift region (23).

6. The power semiconductor device (1) according to any one of the preceding claims, wherein the thickness Tox of the gate insulator (4) along the channel region (220) increases monotonically or strictly monotonically away from the source region (21).

7. The power semiconductor device (1) according to any one of the preceding claims, wherein an outward side (40) of the gate insulator (4) facing the semiconductor body (2) is of planar fashion along the channel region (220).

8. The power semiconductor device (1) according to any one of the preceding claims, wherein a length of the first part (44) is at least 10% and at most 40% of an overall length (L) of the channel region (220) along the gate insulator (4).

9. The power semiconductor device (1) according to any one of the preceding claims, wherein the gate insulator (4) has a second part (47) which is located next to the source region (21), seen along the channel region (220).

10. The power semiconductor device (1) according to the preceding claim, wherein at least one of the following applies:

   - in the second part (47) the gate insulator (4) has a constant thickness and is thinner than in the first part (44), or

   - the thickness Tox of the gate insulator (4) in the second part (44) is between 20 nm and 80 nm inclusive and in the first part (44) is between 120 nm and 250 nm inclusive.

11. The power semiconductor device (1) according to any one of the preceding claims, wherein the thickness Tox of the gate insulator (4) along the channel region (220) varies by at least 20% of a maximum thickness (Tmax) of the gate insulator (4).

12. The power semiconductor device (1) according to any one of the preceding claims, wherein the thickness Tox of the gate insulator (4) along the channel region (220) changes in a stepped manner so that there is at least one step (43) in the thickness Tox of the gate insulator (4) along the channel region (220).

13. The power semiconductor device (1) according to any one of claims 1 to 11, wherein the thickness Tox of the gate insulator (4) along the channel region (220) changes in a continuous, step-less manner.

14. The power semiconductor device (1) according to any one of the preceding claims, wherein the gate insulator (4) is of multi-layer fashion.

15. The power semiconductor device (1) according to any one of claims 1 to 13, wherein the gate insulator (4) is of single-layer fashion so that the gate insulator (4) consists of exactly one continuous layer.

FIG 1

31  4  21

9

220

22

23

2

FIG 2

1

25  32  21  31

20

220

x

L

22

44

2

Tmax

43

23

24

33

FIG 3

1

2  20

22

25

21  4  31

FIG 4

Vth-1= Vth-2= Vth-3

Ic

I_sat-1

I_sat-2

I_sat-3

Ion

Vpinch-off ~(Vg-Vth)

Vce

Vce-sat-(1,2,3)

FIG 5

Vth-2 > Vth-1

Ic

I_sat-1

I_sat-2

Ion

Vpinch-off-(2,1)

Vce

Vce-sat-(1,2)

FIG 6

FIG 7

FIG 8

Tox

150nm

140nm

100nm ----- 9

60nm ..... B
                A
40nm

0        1.5   L=2.5

x/µm

FIG 9

1000                    9
                        A, 1
800
                        B, 1
600

Ic/A
400

200
Ic-on
        Vce-sat
0   5   10  15  20  25

Vce/V

FIG 10

200                9, A
                   B
150
Ic-on

Ic/A   100

50
                Vce-sat
0   0.5   1   1.5   2

Vce/V

FIG 11

FIG 12

FIG 13

25  32  21  31  4                1

20

220        x

22

43

Tmax            44

2

23

40

26

34

FIG 14        1

31  21  20

220            22

43        x

2

L

44

23

FIG 15        1

21  4  31

220        22

x

2

46        L

44

23

FIG 16

FIG 17

FIG 18

FIG 19

Europäisches
Patentamt

European
Patent Office

Office européen
des brevets

## EUROPEAN SEARCH REPORT

Application Number

EP 21 18 6089

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 248 300 A2 (SCHINDENGEN ELECTRIC MFG CO LT [JP]) 9 October 2002 (2002-10-09) | 1,2, 4-13,15 | INV. H01L29/423 |
| Y | * paragraph [0047] - paragraph [0053]; figures 22-25 * <br> * paragraph [0068] - paragraph [0070]; figures 49-50 * <br> ----- | 14 | H01L29/739 H01L29/78 |
| X | US 2016/064550 A1 (SUGIMOTO MASAHIRO [JP] ET AL) 3 March 2016 (2016-03-03) * paragraph [0016] - paragraph [0035]; figure 1 * <br> ----- | 1-3,5,7, 9,10,12 | |
| X | US 2008/166846 A1 (MARCHANT BRUCE D [US] ET AL) 10 July 2008 (2008-07-10) <br><br> * paragraph [0021] - paragraph [0025]; figure 2 * <br> ----- | 1,2,4,5, 7,9-11, 13 | |
| Y | US 2016/093719 A1 (KOBAYASHI KENYA [JP] ET AL) 31 March 2016 (2016-03-31) * paragraph [0082] - paragraph [0090]; figure 11 * <br> ----- | 14 | |

TECHNICAL FIELDS
SEARCHED      (IPC)

H01L

The present search report has been drawn up for all claims

| Place of search | Date of completion of the search | Examiner |
|---|---|---|
| Munich | 6 December 2021 | Lantier, Roberta |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 120 360 A1**

## ANNEX TO THE EUROPEAN SEARCH REPORT
## ON EUROPEAN PATENT APPLICATION NO.

EP 21 18 6089

This annex lists the patent family members relating to the patent documents cited in the above-mentioned European search report.
The members are as contained in the European Patent Office EDP file on
The European Patent Office is in no way liable for these particulars which are merely given for the purpose of information.

06-12-2021

| Patent document cited in search report | | Publication date | Patent family member(s) | | Publication date |
|---|---|---|---|---|---|
| EP 1248300 | A2 | 09-10-2002 | EP | 1248300 A2 | 09-10-2002 |
| | | | JP | 4073176 B2 | 09-04-2008 |
| | | | JP | 2002299619 A | 11-10-2002 |
| | | | US | 2002153558 A1 | 24-10-2002 |
| | | | US | 2005017294 A1 | 27-01-2005 |
| US 2016064550 | A1 | 03-03-2016 | JP | 2016054181 A | 14-04-2016 |
| | | | US | 2016064550 A1 | 03-03-2016 |
| US 2008166846 | A1 | 10-07-2008 | US | 2006237781 A1 | 26-10-2006 |
| | | | US | 2008166846 A1 | 10-07-2008 |
| US 2016093719 | A1 | 31-03-2016 | CN | 105990426 A | 05-10-2016 |
| | | | JP | 6203697 B2 | 27-09-2017 |
| | | | JP | 2016072482 A | 09-05-2016 |
| | | | US | 2016093719 A1 | 31-03-2016 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6503786 B2
- WO 2017112276 A1
- US 20070063269 A1